(19) Europäisches Patentamt
European Patent Office
Office européen des brevets

(11) **EP 4 273 934 A1**

(12) **EUROPEAN PATENT APPLICATION**

(43) Date of publication:
**08.11.2023 Bulletin 2023/45**

(21) Application number: **23171478.3**

(22) Date of filing: **04.05.2023**

(51) International Patent Classification (IPC):
**H01L 29/36** (2006.01)     **H01L 21/329** (2006.01)
**H01L 29/739** (2006.01)     **H01L 29/78** (2006.01)
**H01L 29/861** (2006.01)

(52) Cooperative Patent Classification (CPC):
**H01L 29/861; H01L 29/36; H01L 29/66136;**
H01L 29/7395

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **05.05.2022 CN 202210483446**

(71) Applicants:
• **Nexperia Technology (Shanghai) Ltd.**
**Shanghai 200025 (CN)**
• **Nexperia B.V.**
**6534 AB Nijmegen (NL)**

(72) Inventors:
• **ZHU, Chunlin**
**Manchester (GB)**
• **JIANG, Ke**
**Shanghai (CN)**
• **XIANG, Junli**
**Shanghai (CN)**
• **ZUO, Huiling**
**Shanghai (CN)**
• **ZHANG, Xukun**
**Shanghai (CN)**
• **SHI, Jinshan**
**Shanghai (CN)**
• **FANG, Yuan**
**Shanghai (CN)**

(74) Representative: **Pjanovic, Ilija**
**Nexperia B.V.**
**Legal & IP**
**Jonkerbosplein 52**
**6534 AB Nijmegen (NL)**

(54) **SEMICONDUCTOR DEVICE AND METHOD FOR MANUFACTURING THE SAME**

(57)    The present invention claims a semiconductor device and a method for manufacturing the same, the semiconductor device comprising: a semiconductor body having a first surface and a second surface, the semiconductor body comprising: a depletion region, a drift region having a first conductivity type, an island region having the first conductivity type, a buffer region having the first conductivity type, the drift region is more proximal to the first surface of the semiconductor body than the buffer region, the depletion region is located within the drift region, wherein the island region is located within the drift region, an ion concentration of the first conductivity type of the island region is higher than an ion concentration of the first conductivity type of the drift region.

FIG. 5

EP 4 273 934 A1

**Description**

**TECHNICAL FIELD**

The present invention relates to a semiconductor device and a method for manufacturing the same. In particular, the present invention relates to a semiconductor device having soft switching performance and a method for manufacturing the same.

**BACKGROUND**

With the development of power electronics technology, fast recovery diodes are widely used in electronic circuits as the most fundamental power devices. In highspeed switching circuits, in order to reduce a peak voltage during the turning-off of the diode, more requirements are on fast recovery diodes, and reverse recovery characteristics of the diodes are required to be softer. That is, in a diode reverse recovery waveform, a reverse recovery peak current is lower, and a current change rate during reverse recovery process is smaller.

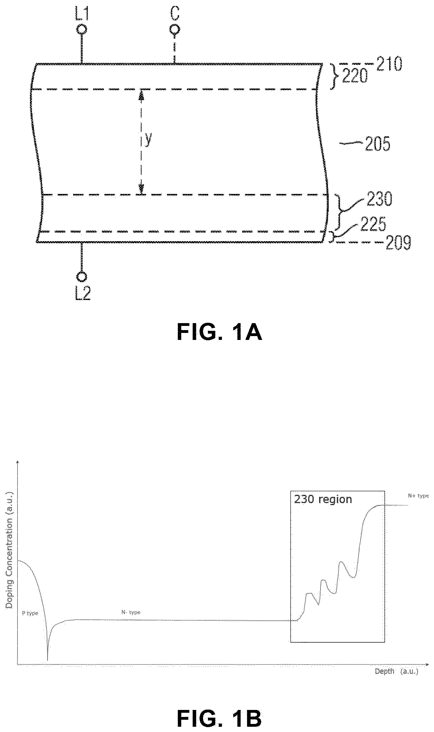

Figs. 1A and 1B illustrate a cross-sectional view of a semiconductor device of the prior art, wherein a field stop region 230 is more proximal to a device bottom surface 209 than a drift region 205. As shown in Fig. 1A, in the field stop region 230, multiple ion implantations with different concentrations, e.g., step-peak doping, are performed to reduce switching losses in a transistor. Further, the field stop region 230 of the device is more proximal to the bottom of the device, the range of ion implantation energy of the field stop region 230 is wider, and the ion implantation energy is not related to a device application voltage, and if the depth position of ion implantation is not proper, the device would not exhibit softer reverse recovery characteristics.

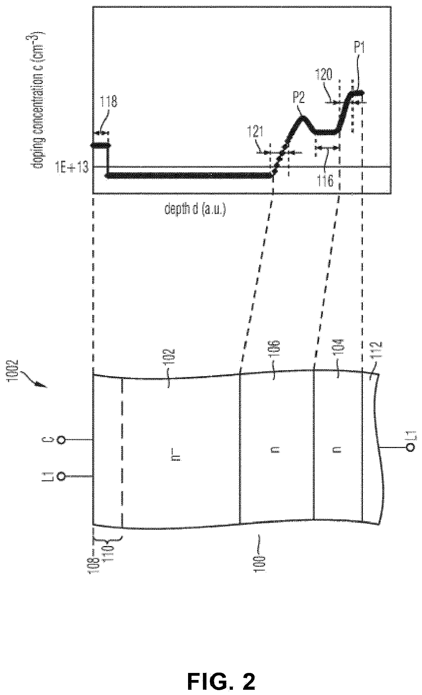

Fig. 2 illustrates a cross-sectional view of another semiconductor device of the prior art, wherein field stop regions 104 and 106 are more proximal to a device bottom surface 112 than the drift region 102. As shown in Fig. 2, a single peak doping is performed in the field stop region 106 and a higher concentration doping is performed in the field stop region 104 to slow down oscillating behaviours during the turning-off. Further, the field stop regions 104 and 106 of the device are more proximal to the bottom of the device, the range of ion implantation energy of the field stop regions 104 and 106 is wide, which is in the range of 4um to 55um, and the ion implantation energy is not related to a device application voltage, and if the depth position of ion implantation is not proper, the device would not exhibit softer reverse recovery characteristics.

**SUMMARY**

The present invention discloses a semiconductor device, comprising: a semiconductor body having a first surface and a second surface, the semiconductor body comprising: a depletion region, a drift region having a first conductivity type, an island region having the first conductivity type, a buffer region having the first conductivity type, the drift region is more proximal to the first surface of the semiconductor body than the buffer region, the depletion region is located within the drift region, wherein the island region is located within the drift region, an ion concentration of the first conductivity type of the island region is higher than an ion concentration of the first conductivity type of the drift region.

As an example of the present invention, a Poisson's equation in the drift region is calculated as below:

$$\frac{d^2V}{dx^2} = -\frac{dE}{dx} = -\frac{Q(x)}{\varepsilon_S} = -\frac{qN_D}{\varepsilon_S}$$

wherein Q(x) is a charge within the depletion region, $\varepsilon_S$ is a dielectric constant for the semiconductor, q is an electron charge, and $N_D$ is an ion impurity concentration in the drift region.

As an example of the present invention, wherein the body of the semiconductor device further comprises: a semiconductor region of a second conductivity type, an ion concentration of the semiconductor region of a second conductivity type is higher than that of the drift region such that the depletion region extends only towards the drift region to maintain a blocking voltage when a reverse voltage is applied to the semiconductor device.

As an example of the present invention, a width of the depletion region is $W_D$, and an electric field value becomes zero at x=$W_D$, and an electric field distribution equation is obtained as below:

$$V(x) = \int_0^x E(x)dx = \frac{qN_D}{\varepsilon_S}(W_Dx - \frac{x^2}{2})$$

wherein the equation is obtained by using a boundary condition that the potential is zero at x=0 within the semiconductor region of the second conductivity type.

As an example of the present invention, by using the boundary condition that the voltage at the width of the depletion region $W_D$ is equal to an applied reverse bias $V_a$, $V_{W_D} = V_a$, the width of the depletion region $W_D$ is given by:

$$W_D = \sqrt[2]{\frac{2\varepsilon_S V_a}{qN_D}}$$

a position of a top surface of the island region is in a range of 65%$W_D$ to 80% $W_D$, a position of a bottom surface of the island region is at $W_D$, and a thickness of the island region is in a range of 20%$W_D$ to 35% $W_D$.

As an example of the present invention, the body of the semiconductor device further comprises: a semiconductor region of a second conductivity type, an ion concentration of the semiconductor region of a second conductivity type is close to the ion concentration of the drift region, the depletion region extends towards the semiconductor region of a second conductivity type and the drift region to maintain a blocking voltage when a reverse voltage is applied to the semiconductor device.

As an example of the present invention, a width of the depletion region $W_D$ is calculated as below:

$$W_D = \sqrt[2]{\frac{2\varepsilon_S V_a}{qN_D} \left(\frac{N_A}{N_A + N_D}\right)}$$

wherein $\varepsilon_S$ is a dielectric constant for the semiconductor, q is an electron charge, $N_D$ is an ion impurity concentration in the drift region, $N_A$ is an ion impurity concentration in the semiconductor region of the second conductivity type, and $V_a$ is a reverse bias applied to the semiconductor, a position of a top surface of the island region is in a range of 65%$W_D$ to 80% $W_D$, a position of a bottom surface of the island region is at $W_D$, and a thickness of the island region is in a range of 20%$W_D$ to 35% $W_D$.

As an example of the present invention, an ion concentration of the first conductivity type of the buffer region is higher than that of the first conductivity type of the drift region.

As an example of the present invention, the top surface of the island region is more proximal to the first surface of the semiconductor than the bottom surface of the island region.

As an example of the present invention, the island region is doped by single peak doping or multi peak doping and the shape of ion doping profile of the island region comprises any one of the followings: triangle single peak, quadrangle single peak, irregular multi peaks.

As an example of the present invention, the semiconductor device comprises switching devices such as a fast recovery diode, an ultra-fast recovery diode, a standard diode, a MOSFET, and an IGBT.

The present invention further provides a method for manufacturing a semiconductor device, comprising the steps of: forming a drift region of a first conductivity type on a semiconductor body, forming a semiconductor region of a second conductivity type on a first surface of the semiconductor body, forming a semiconductor region of a first conductivity type on a second surface of the semiconductor body, forming an island region of the first conductivity type and a buffer region of the first conductivity type on the semiconductor body, the drift region is more proximal to the first surface of the semiconductor body than the buffer region, a depletion region is located within the drift region, wherein the island region is located within the drift region, an ion concentration of the first conductivity type of the island region is higher than that of the first conductivity type of the drift region.

As an example of the present invention, the Poisson's equation in the drift region is calculated as below:

$$\frac{d^2V}{dx^2} = -\frac{dE}{dx} = -\frac{Q(x)}{\varepsilon_S} = -\frac{qN_D}{\varepsilon_S}$$

wherein $Q(x)$ is a charge within the depletion region, $\varepsilon_S$ is a dielectric constant for the semiconductor, q is an electron charge, and $N_D$ is an ion impurity concentration in the drift region.

As an example of the present invention, an ion concentration of a semiconductor region of the second conductivity type is higher than that of the drift region, the depletion region extends only towards the drift region to maintain a blocking voltage when a reverse voltage is applied to the semiconductor device.

As an example of the present invention, a width of the depletion region is $W_D$, since an electric field value becomes zero at x=$W_D$, an electric field distribution equation is obtained as below:

$$V(x) = \int_0^x E(x)dx = \frac{qN_D}{\varepsilon_S}\left(W_D x - \frac{x^2}{2}\right)$$

wherein the equation is obtained by using a boundary condition that the potential is zero at x=0 within the semiconductor region of the second conductivity type.

As an example of the present invention, by using the boundary condition that the voltage at the width of the depletion region $W_D$ is equal to the applied reverse bias $V_a$, $V_{W_D} = V_a$, the width of the depletion region $W_D$ is given by:

$$W_D = \sqrt[2]{\frac{2\varepsilon_S V_a}{qN_D}}$$

a position of a top surface of the island region is in a range of 65% $W_D$ to 80% $W_D$, a position of a bottom surface of the island region is at $W_D$, and a thickness of the island region is in a range of 20% $W_D$ to 35% $W_D$.

As an example of the present invention, an ion concentration of a semiconductor region of the second conductivity type is close to that of the drift region, the drift region extends towards the semiconductor region of the second conductivity type and the drift region to maintain a blocking voltage when a reverse voltage is applied to the semiconductor device.

As an example of the present invention, a width of the depletion region $W_D$ is calculated as below:

$$W_D = \sqrt[2]{\frac{2\varepsilon_S V_a}{q N_D} \left(\frac{N_A}{N_A + N_D}\right)}$$

wherein $\varepsilon_S$ is a dielectric constant for the semiconductor, q is an electron charge, $N_D$ is an ion impurity concentration in the drift region, $N_A$ is the ion impurity concentration in the semiconductor region of the second conductivity type, and $V_a$ is a reverse bias applied to the semiconductor, a position of a top surface of the island region is in a range of 65%$W_D$ to 80% $W_D$, a position of a bottom surface of the island region is at $W_D$, and a thickness of the island region is in a range of 20% $W_D$ to 35% $W_D$.

As an example of the present invention, wherein an island region is formed by a proton implantation process or an EPI growth process.

As an example of the present invention, the top surface of the island region is more proximal to the first surface of the semiconductor than the bottom surface of the island region.

As an example of the present invention, the island region is doped by single peak doping or multi peak doping and the shape of ion doping profile of the island region comprises any one of the followings: triangle single peak, quadrangle single peak, triangle multi peak, quadrangle multi peaks.

As an example of the present invention, the position of the top surface of the island region is formed in a range 65%$W_D$- 80% $W_D$, the position of the bottom surface of the island region is formed at $W_D$, comprising: determining an implantation depth of the island region according to the width $W_D$ of the depletion region, and determining a proton implantation energy according to the corresponding relationship between the proton implantation energy and the implantation depth of the island region, such that the position of the top surface of the island region is formed in a range 65% $W_D$ to 80% $W_D$, and the position of the bottom surface of the island region is formed at $W_D$.

## BRIEF DESCRIPTION OF THE DRAWINGS

The accompanying drawings are included to provide a further understanding of the prevent invention and are incorporated in and constitute a part of this description. The drawings comprise embodiments of the prevent invention, and together with the description, serve to explain the principles of the prevent invention. Embodiments of the present invention and intended advantages would be readily appreciated by reference to the following detailed description.

Fig. 1A illustrates a cross-sectional view of a semiconductor device in the prior art ;

Fig. 1B illustrates a schematic view of doping profile of the semiconductor device shown in Fig. 1A;

Fig. 2 illustrates a cross-sectional view and a schematic view of doping profile of another semiconductor device in the prior art;

Fig. 3 illustrates a cross-sectional view of the semiconductor device of one embodiment of the present invention;

Fig.4 illustrates a cross-section and its doping profile of the semiconductor device of the present invention as shown in Fig. 3;

Fig. 5 illustrates a schematic view of doping profile of the semiconductor device of the present invention;

Fig. 6 illustrates another schematic view of doping profile of the semiconductor device of the present invention;

Fig. 7 illustrates another schematic view of doping profile of the semiconductor device of the present invention;

Fig.8 illustrates a cross-section during a method for manufacturing the semiconductor device of an embodiment of the present invention;

Fig.9 illustrates a cross-section during a method for manufacturing the semiconductor device of an embodiment of the present invention;

Fig.10 illustrates a cross-section during a method for manufacturing the semiconductor device of an embodiment of the present invention;

Fig.11 illustrates a cross-section during a method for manufacturing the semiconductor device of an embodiment of the present invention;

Fig. 12 is a schematic view of the distribution of an electric field in the semiconductor body over time during a reverse recovery process of the semiconductor device having the island region of the present invention;

Fig. 13 is a schematic view of the distribution of carriers in the semiconductor body over time during a reverse recovery process of the semiconductor device having the island region of the present invention.

## DETAILED DESCRIPTION

For better understanding by a person skilled in the art to the technical solution of the present invention, the following detailed description of the semiconductor device and the method for manufacturing the same of the present invention is made with reference to the accompanying drawings as non-limiting examples.

It should also be noted that for the purposes of describing these exemplary embodiments herein, the drawings illustrate general features of the method and device of the exemplary embodiments of the invention. These drawings, however, are not to scale and may not precisely reflect the features of any given embodiment, and should not be interpreted as defining or limiting the numerical ranges or characteristics of the exemplary embodiments within the scope of the present invention.

The terms "having", "including", "comprising", "containing", and the like, are open-ended and indicate the presence of a stated structure, element, or feature, but do not preclude the presence of additional elements or features. The articles "a," "an," or "the" are intended to encompass the plural as well as the singular meanings, unless the context clearly indicates otherwise.

The figures illustrate relative doping concentrations by indicating "-" or "+" next to the doping type "n" or "p". For example, "n-" means a doping concentration lower than that of an "n" doped region, while an "n+" doped region has a higher doping concentration than that of an "n" doped region. Doped regions of the same relative doping concentration do not necessarily have the same absolute doping concentration. For example, two different "n" doped regions may have the same or different absolute doping concentrations.

In the examples of the present invention, the second surface of the semiconductor body is considered to be formed by a bottom or backside surface, while the first surface is considered to be formed by a top surface, a front surface or a main surface of the semiconductor substrate. The terms "above...", "below..." and "more proximal to...than..." as used in this description describe a relative position of one structural feature to another structural feature.

In the examples of the present invention, the first conductivity type is n doped and the second conductivity type is p doped.

The semiconductor device of the present invention may comprise switching devices such as a fast recovery diode, an ultra-fast recovery diode, a standard diode, a MOSFET, and an IGBT, but is not limited thereto.

The present invention relates to the manufacturing a semiconductor device having an implantation layer (e.g., an n type island region) from a bottom surface of a semiconductor body. Since an implantation depth is specially designed, the implantation depth could be well placed. When the semiconductor device is subjected to a reverse voltage, a space charge region in the device would extend. When the space charge region extends to an n-type island layer formed by implantation, extension of the charge region would be suppressed, and meanwhile, the space charge region and an electric field extend more slowly, and more carriers are distributed in the bottom region (more proximal to the bottom surface of the semiconductor body) of the device, leading to a long tail current to achieve soft recovery performance and switching characteristics. Softness refers to a slope of current drop during the drop of reverse recovery current, wherein the steeper the slope, the harder the turn-off, and vice versa. The following embodiments are provided to help a person skilled in the art to better understand the technical solutions of the present invention.

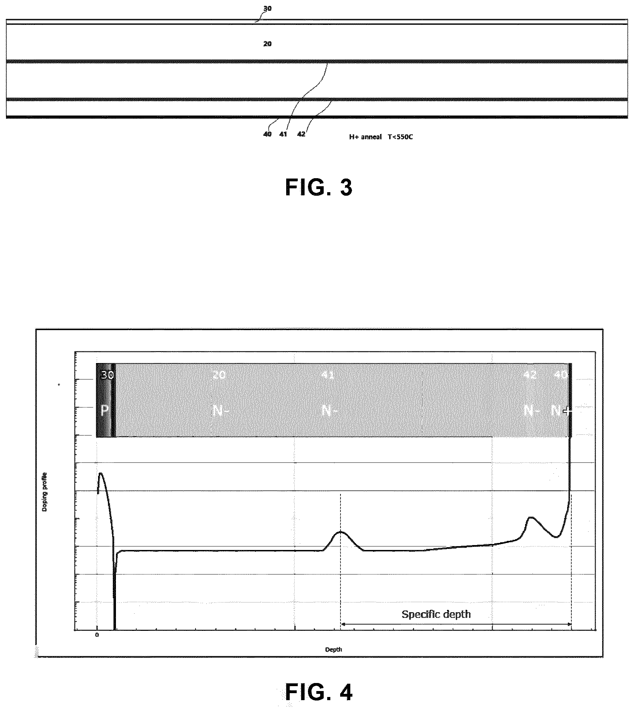

Fig. 3 illustrates a cross-sectional view of the semiconductor device of one embodiment of the present invention. The semiconductor device comprises a semiconductor body having a first surface formed by a top surface of the semiconductor body, and a second surface formed by a bottom surface of the semiconductor body. The semiconductor body further comprises one or more functional layers, for example, the semiconductor body comprises a p+ type semiconductor region 30 of the first surface, an n- type drift region 20, an n- type island region 41, an n- type buffer region 42, and an n+ type semiconductor region 40 of the second surface. A PN junction is formed between the p+ type semiconductor region 30 of the first surface and the n- type drift region 20 , and a space charge region is generated in a portion in the middle of the PN junction (for example, near the interface between the p+ type semiconductor region 30 and the n- type drift region 20) due to a diffusion motion of free electrons and a drift motion caused by an internal electric field. This space charge region is formed by exposing uncompensated ionized impurity charges due to carriers being repelled to the body by the electric field. Since the ionized impurity charge is fixed space charge, it is referred to as a space charge region, which is also referred to as a depletion region. There are electric field and potential change in the space charge region. The potential change depends on the distribution of impurities in the semiconductor, and the width of the space charge region depends on the impurity concentration of the semiconductor. The larger the doping concentration, the narrower the width of the corresponding space charge region. In addition, the width of the space charge region is also controlled by the applied voltage - when the direction of the applied voltage enhances the electric field of the space charge region, the space charge region is widened. By contrast, when the applied voltage weakens the electric field of the space charge region, the space charge region is narrowed.

In the examples of the present invention, the doping concentration of the p+ type semiconductor region 30 of the first surface is much higher than that of the n- type drift region 20, therefore it can be understood that the depletion region extends mainly (or only) in the lightly doped n type region. Of course, the present invention is not limited thereto. When the doping concentration of the p+ type semiconductor region 30 of the first surface is close to the doping concentration of the n- type drift region 20, the depletion region may extend to both the p type semiconductor region 30 and the n type drift region 20.

In the examples of the present invention, the n- type drift region 20 comprises the depletion region and a drift region outside the width of the depletion region.

In the examples of the present invention, an n- type island region 41 is located within the n- type drift region 20, but not within a buffer region 42 which is more proximal to the bottom surface of the semiconductor body than the drift region 20, the ion doping concentration of the n- type island regions 41 is higher than that of the n- type drift region 20. As an example, the peak concentration of the island region 41 may range from 1 to 10 times the doping concentration of the drift region 20.

Fig.4 illustrates a cross-section and its doping profile of the semiconductor device of the present invention as shown in Fig. 3. As can be seen from Fig. 4, the n- type island region 41 is located in the n- type drift region 20, the ion doping concentration of the n- type island region 41 is higher than that of the n- type drift region 20. The ion doping concentration of the n- type buffer region 42 is higher than that of the n- type drift region 20. The ion doping concentration of the island region 41 and the buffer region 42 could be set independently, and the design of the island region 41 could be well combined with the design of the buffer region 42 without conflict.

While the ion doping concentration of the n+ type semiconductor region 40 is higher than that of the n- type buffer region 42. In addition, the ion doping concentration of the p+ type semiconductor region 30 is much higher than that of the n- type drift region 20. Of course, the present invention is not limited thereto, and the ion doping concentration of the p + type semiconductor region 30 may be similar to that of the n-type drift region 20. The n- type island region 41 and its depth are designated and placed at a suitable position of the n-type drift region 20, and the depth of the n- type island region 41 is closely related to the applied voltage of the semiconductor device.

When a reverse voltage is applied to the semiconductor device, the space charge region would extend to maintain a blocking voltage. As an example of the present invention, the semiconductor device is a single-sided abrupt junction, the doping concentration of the p + type semiconductor region 30 of the first surface is much higher than that of the n- type drift region 20, and the depletion region extends mainly (or only) in the lightly doped n-type region. The Poisson's equation in the drift region is calculated as below:

$$\frac{d^2V}{dx^2} = -\frac{dE}{dx} = -\frac{Q(x)}{\varepsilon_S} = -\frac{qN_D}{\varepsilon_S}$$

wherein $Q(x)$ is a charge within the depletion region, $\varepsilon_S$ is a dielectric constant for the semiconductor, q is an electron charge, and $N_D$ is an ion impurity concentration in the drift region.

An electric field distribution equation could be obtained as below by combining the equation with a boundary condition where the electric field value becomes zero at the width of the depletion region (the edge of the depletion region), i.e., at $x=W_D$:

$$V(x) = \int_0^x E(x)\,dx = \frac{qN_D}{\varepsilon_S}\left(W_D x - \frac{x^2}{2}\right)$$

It should be noted that the above equation is obtained by using the boundary condition that the potential is zero at $x=0$ in the p+ type semiconductor region 30.

As shown in the above equation, potential $V(x)$ changes quadratically. By using the boundary condition that the voltage at the width of the depletion region $W_D$ is equal to the applied reverse bias $V_a$:

$$V_{W_D} = V_a,$$

the width of the depletion region $W_D$ is given by:

$$W_D = \sqrt[2]{\frac{2\varepsilon_S V_a}{qN_D}}$$

the position of the top surface of the island region is in a range 65%$W_D$ - 80% $W_D$, the position of the bottom surface of the island region is at $W_D$, and a thickness of the island region is in a range 20%$W_D$ - 35% $W_D$.

Since the width $W_D$ of the depletion region and the applied reverse bias $V_a$ have the above equational relationship, it can be seen that the implantation depth of the n- type island region 41 is closely related to a working voltage of the semiconductor device. When the semiconductor device is subjected to a reverse voltage, the electric field in the depletion region would be terminated at the applied voltage. By precisely controlling the implantation depth of the n- type island region 41, the bottom surface of the n- type island region 41 is made to fall at the termination of the electric field, i.e., at the edge $W_D$ of the depletion region. Therefore, extension of the depletion region would be suppressed when the depletion region extends to the n- type island region, and the depletion region and the electric field extend more slowly to allow more carriers to be distributed at the bottom of the device, leading to a long tail current to achieve soft recovery performance and switching characteristics.

As one example of the present invention, when designing a semiconductor device, a designer would know relevant information of the designed device, such as semiconductor thickness, p-side thickness, and corresponding width of the depletion region under a certain voltage. The implantation depth of the island region could be determined by relevant information of the device, and a proton implantation energy is determined according to corresponding relationship between the proton implantation energy and the implantation depth of the island region, such that the position of a top surface of the island region is formed in a range 65%$W_D$ - 80% $W_D$, and the position of a bottom surface of the island region is formed at $W_D$.

As one example of the present invention, a top surface of the island region is more proximal to the first surface of the semiconductor than a bottom surface of the island region, that is, the top surface of the island region is more proximal to the top surface of the semiconductor than the bottom surface of the island region.

In another example of the present invention, when the doping concentration of the p+ type semiconductor region 30 of the first surface is similar to that of the n- type drift region 20, the depletion region could extend to both the p type semiconductor region 30 and the n type drift region 20. A main voltage withstand region is still within the n type drift region 20. The voltage withstand principle in the n type drift region 20 is the same as that of the single-sided abrupt junction. The width of the depletion region $W_D$ in the case of non-single-sided abrupt junction is obtained from the Poisson's equation and boundary condition.

$$W_D = \sqrt[2]{\frac{2\varepsilon_S V_a}{qN_D} \left(\frac{N_A}{N_A + N_D}\right)}$$

Wherein, $N_A$ is the ion impurity concentration in the p type semiconductor region.

Regarding the above equation, the position of the top surface of the island region is in a range 65%$W_D$ - 80% $W_D$, the position of the bottom surface of the island region is at $W_D$, and a thickness of the island region is in a range 20%$W_D$ - 35% $W_D$.

Regarding the above equation, the bottom surface of the n- type island region 41 is made to fall at the termination of the electric field, i.e., at the width $W_D$ of the depletion region. Therefore, extension of the depletion region would be suppressed when the depletion region extends to the n- type island region, and the depletion region and the electric field extend more slowly, that is, the island region will slow down the extension of the space charge region, Therefore, more carriers are distributed at the bottom of the device, leading to a long tail current to achieve soft recovery performance and switching characteristics.

In the examples of the present invention, the n-type island region 41 and its specific implantation depth are closely related to the applied voltage of the semiconductor device, since proton implantation energy would determine a implantation range (e.g., implantation depth), and the implantation depth of the n-type island region could be queried by checking the corresponding relationship between implantation energy and range.

As one example of the present invention, when designing a semiconductor device, a designer should first know an application voltage value and design a corresponding island position according to the application voltage value. Different application voltages and different application scenes are selected to design different devices.

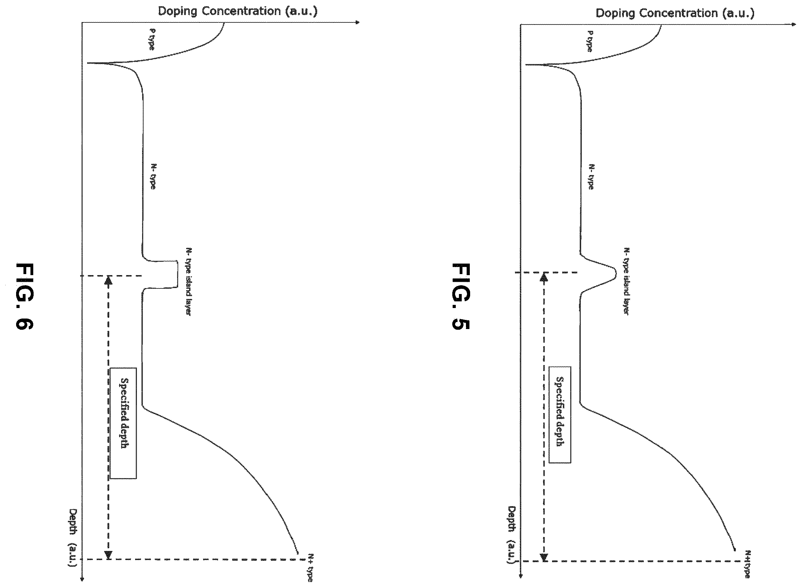

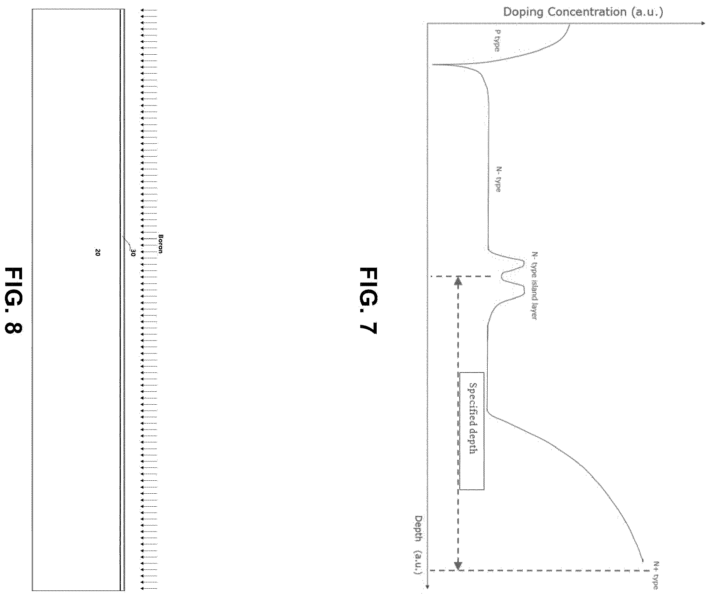

Figs. 5-7 illustrate a schematic view of a plurality of different doping profiles of the semiconductor device of the present application. The shape of the doping profile of the n- type island region shown in Fig. 5 is a triangle single peak, the shape of the doping profile of the n- type island region shown in Fig. 6 is a quadrangle single peak, and the shape of the doping profile of the n- type island region shown in Fig. 7 is an irregular multi peaks, wherein the irregular multi peaks may comprise triangle multi peaks, quadrangle multi peaks or other shape combinations.

In the examples of the present invention, it should be noted that single-peak doping does not refer to a single-time doping, but may be multiple-times doping, and the final effect is single-peak. Multi peak doping does not refer to multiple-times doping, and the final effect is multi peak, of course, multiple-times doping could be used to form multi peaks. Triangle peak means that there is only one peak point, and quadrangle peak means that there is a peak point with a certain thickness.

The semiconductor body of the present application may be a semiconductor wafer, such as a silicon wafer. According to one example of the present invention, the semiconductor body is a silicon wafer obtained by a Czochralski growth process, e.g. a magnetron Czochralski (MCZ) silicon wafer. For the diffusion of silicon materials, boron is the most commonly used p type dopant, while arsenic and phosphorus are commonly used n type dopants. These three elements have extremely high solubility in silicon in a diffusion temperature range, which may be higher than $5 \times 10^{20} \text{cm}^{-3}$.

The present invention further provides a method for manufacturing the semiconductor device as shown in Fig. 3, including the following steps S11 to S14.

In step S11, a p+ type semiconductor region 30 is formed on the first surface of the semiconductor body. As shown in Fig. 8, a p+ type semiconductor region 30 is formed on the upper surface of the semiconductor body, for example, a boron implantation process may be used. The p+ type semiconductor region 30 may serve as an anode of the semiconductor diode.

In the examples of the present invention, the n-type drift region 20 may be formed on the semiconductor body by arsenic and phosphorous doping before the p+ type semiconductor region 30 is formed. In an example of the present invention, the n-type drift region 20 comprises a depletion region and a drift region outside the width of the depletion region.

The semiconductor junction of the present invention may be an abrupt junction, and in order to ensure that the depletion region extends only in the lightly doped n type region when a reverse voltage is applied, the doping concentration of the p+ type semiconductor region 30 at the upper surface is much higher than that of the n- type drift region 20. Of course, the present invention is not limited thereto. The doping concentration of the p+ type semiconductor region 30 of the first surface may be similar to that of the n- type drift region 20, and the depletion region may extend in both the p type semiconductor region 30 and the n type drift region 20.

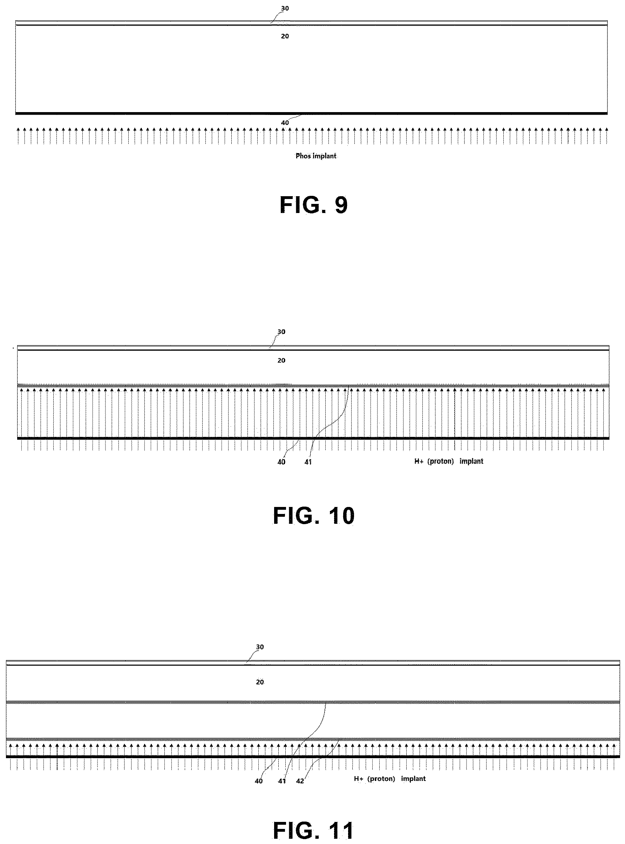

In step S12, an n+ type semiconductor region 40 is formed on the second surface of the semiconductor body, as shown in Fig. 9, the n+ type semiconductor region 40 is formed on the bottom surface of the semiconductor body, for example, a phosphorus implantation process may be used. The n+ type semiconductor region 40 may serve as a cathode of the semiconductor diode.

In the examples of the present invention, the p+ type semiconductor region 30 and the n+ type semiconductor region 40 are formed by an ion implantation process, which is a dominant doping technique in IC manufacturing. By ionizing impurities and accelerating them by an electric field, these ionized impurities are directly injected into a silicon wafer to achieve the purpose of doping.

In step S13, an n- type island region 41 and an n- type buffer region 42 are also formed in sequence on the semiconductor body. As shown in Figs. 10 and 11, the n- type island region 41 and the n- type buffer region 42 are formed by using an ion implantation process at the bottom surface of the semiconductor body. The implantation may be performed using H+ (proton).

Of course, in another embodiment of the present application, the n- type island region 41 may be formed by an EPI growth process. When EPI growth is used, the EPI growth is gradually performed, the rate and time of EPI growth are monitored, and the thickness of the EPI is monitored to form a buffer region within the semiconductor body. When the thickness reaches a desired thickness value, the EPI menu is changed, and the EPI doping is controlled, and growth is continued to form the n- type island region 41. When the growth of the n-type island region 41 is completed, the EPI menu is changed, and the EPI is continued to grow, such that the n- type drift region is continuously formed to the required EPI thickness.

In the examples of the invention, the n- type island region 41 is located within the n-type drift region 20 but not within the buffer region 42, the buffer region 42 is more proximal to the bottom surface of the semiconductor body than the drift region 20, the ion doping concentration of the n-type island regions 41 is higher than that of the n- type drift region 20. As an example, the peak concentration of the island region 41 may range from 1 to 10 times the doping concentration of the drift region 20. The ion doping concentration of the n- type buffer region 42 is higher than that of the n- type drift region 20, while the ion doping concentration of the n+ type semiconductor region 40 is higher than that of the n- type buffer region 42. In one example of the present application, the ion doping concentration of the p+ type semiconductor region 30 is much higher than that of the n-type drift region 20. In another example of the present application, the ion doping concentration of the p+ type semiconductor region 30 is similar to that of the n- type drift region 20. The present invention specifies an implantation depth of the n- type island region 41 and places it in an appropriate location of the n- type drift region 20. The implantation depth of the n- type island region 41 is closely related to the application voltage of the semiconductor device.

In the examples of the present application, to reduce a reverse leakage current, the doping concentrations of the island region 41 and the buffer region 42 should be high enough to prevent the depletion region from extending to the n+ type semiconductor region 40 at the bottom of the semiconductor body.

In step S14, a wafer annealing process is used to form the semiconductor device shown in Fig. 3. Annealing process will heat the ion-implanted silicon wafer at a certain temperature and under the protection of vacuum or high-purity gas such as hydrogen, nitrogen, argon, etc., and undergo heat treatment for an appropriate time to partially or completely eliminate the damage in the silicon wafer, and the lifetime and mobility of minority carriers would also be recovered to varying degrees. The doped impurities are electrically activated, and the annealing process could use ordinary thermal annealing, diffusion effects, rapid thermal annealing (RTA), etc..

In the method of manufacturing the semiconductor device as shown in Fig. 3, the same calculation equation as that of the semiconductor device shown in Fig. 3 is used to determine the width of the depletion region. When the doping concentration of the p+ type semiconductor region 30 is much higher than that of the n- type drift region 20, the depletion region extends mainly (or only) in the lightly doped n type region.

The width of the depletion region $W_D$ could be obtained by the following equation:

$$W_D = \sqrt[2]{\frac{2\varepsilon_S V_a}{qN_D}}$$

Wherein $\varepsilon_S$ is a dielectric constant for a semiconductor, q is an electron charge, and $N_D$ is an ion impurity concentration in the drift region, and $V_a$ is an applied reverse bias.

When the doping concentration of the p+ type semiconductor region 30 is close to that of the n- type drift region 20, the depletion region extends in both the p type semiconductor region 30 and the n type drift region 20. A voltage withstand region is still within the n type drift region 20. The voltage withstand principle in the n type drift region 20 is the same as that of the single-sided abrupt junction. The width of the depletion region in the case of non-single-sided abrupt junction is obtained from the Poisson's equation and the boundary condition.

The width $W_D$ of the depletion region could be obtained by the following equation:

$$W_D = \sqrt[2]{\frac{2\varepsilon_S V_a}{qN_D} \left(\frac{N_A}{N_A + N_D}\right)}$$

Wherein, $N_A$ is the ion impurity concentration in the p type semiconductor region.

The position of the top surface of the island region is formed in a range 65%$W_D$ - 80% $W_D$, the position of the bottom surface of the island region is formed at $W_D$, and a thickness of the island region is in a range 20%$W_D$ - 35% $W_D$.

Since the width of the depletion region $W_D$ and the applied reverse bias $V_a$ have the above equation relationship, it can be seen that the implantation depth of the n- type island region 41 is closely related to a working voltage of the semiconductor device. When the semiconductor device is subjected to a reverse voltage, the electric field in the depletion region would terminate at the applied voltage. By precisely controlling the implantation depth of the n- type island region 41, the bottom surface of the n- type island region 41 is made to fall at the termination of the electric field, i.e., at the edge $W_D$ of the depletion region. Therefore, extension of the depletion region would be suppressed when the depletion region extends to the n- type island region, and the depletion region and the electric field extend more slowly, and more carriers are distributed at the bottom of the device, leading to a long tail current to achieve soft recovery performance and switching characteristics.

As one example of the present invention, a top surface of the island region is more proximal to the first surface of the semiconductor than a bottom surface of the island region, that is, the top surface of the island region is more proximal to the top surface of the semiconductor than the bottom surface of the island region.

In one example of the present invention, the n-type island region 41 and its specific implantation depth are closely related to the application voltage of the semiconductor device, since proton implantation energy would determine an implantation range (e.g., implantation depth), and the implantation depth of the n- type island region could be queried by checking the corresponding relationship between implantation energy and range.

Figs. 5-7 illustrate a schematic drawing of a plurality of different doping profiles of the semiconductor device of the present application. The shape of the doping profile of the n-type island region shown in Fig. 5 is a triangle single peak, the shape of the doping profile of the n-type island region shown in Fig. 6 is a quadrangle single peak, and the shape of the doping profile of the n-type island region shown in Fig. 7 is an irregular multi peaks, wherein the irregular multi peaks may comprise triangle multi peaks, quadrangle multi peaks or other shape combinations.

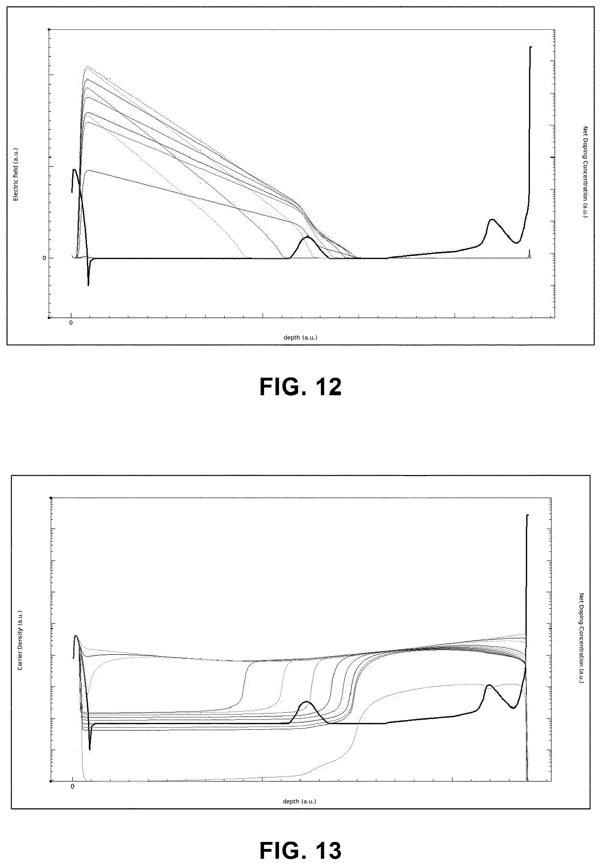

To demonstrate the improvement of the present invention, Figs. 12-13 illustrate a schematic view of the result of the improved switching performance of the device after introduction of the n type island region of the present invention. Fig. 12 is a schematic view of the distribution of an electric field in a semiconductor body over time during a reverse recovery process of the semiconductor device having the island region of the present invention.

In Fig. 12, the ordinate (Y-axis, left side) represents an electric field, the ordinate (Y-axis, right side) represents a doping concentration in the semiconductor body, and the abscissa (X-axis) represents a distance from the top surface of the semiconductor to the bottom surface of the semiconductor. Taking diode turning-off as an example, in the process of diode turning-off, there would be a phenomenon of reverse recovery. The device takes time to perform reverse recovery. Fig. 12 is used for understanding the change of electric field distribution in the semiconductor body over time during the reverse recovery process. As time goes on, the electric field distribution at different time points is shown in Fig. 12, the ordinate (Y-axis, right side) represents the doping concentration in the semiconductor body, the dark lines in Fig. 12 represent doping. It can be seen that the electric field drops to zero more rapidly after passing through the island region, and the influence of the island on the electric field distribution could help to understand the influence of the island region on the depletion region in the semiconductor body.

Fig. 13 is a schematic view of the distribution of carriers in a semiconductor body over time during a reverse recovery process of the semiconductor device having the island region of the present invention. In Fig. 13, the ordinate (Y-axis, left side) represents the concentration of carriers in the body, the ordinate (Y-axis, right side) represents the doping concentration in the semiconductor body, and the abscissa (X-axis) represents a distance from the top surface of the semiconductor to the bottom surface of the semiconductor. Taking diode turning-off as an example, in the process of diode turning-off, there would be a phenomenon of reverse recovery. The device takes time to perform reverse recovery. Fig. 13 is used for understanding the change of carrier concentration in the semiconductor body over time during the reverse recovery process. As time goes on, carrier distribution at different time points is shown in Fig. 13, the ordinate (Y-axis, right side) represents the doping concentration in the semiconductor body, the dark lines in Fig. 13 represent doping. It can be seen that the decline of carrier concentration is suppressed, and the decline is slower than before. It could help to understand the influence of the island region on carrier distribution in the semiconductor body.

The n type island region of the present invention and its depth are specified and well placed. The depth of the n type island region is closely related to a device application voltage. For a given applied voltage, the corresponding n type island region will be set. When a space charge region/ electric field extends to the n type island region, the extension of the space charge region/electric field will be suppressed. The space charge region/electric field extends more slowly, i.e., the island region would slow down extension of the space charge region. Therefore, more carriers are distributed at the bottom of the device, leading to a long tail current to achieve the recovery performance of soft switching characteristics. Soft recovery performance helps to reduce voltage spike, suppress voltage oscillation, reduce EMI in circuits, lower switching losses both in FRD and IGBT transistor.

Finally, it should be noted that: the above embodiments are only used to illustrate the technical solutions of the present invention, and not to limit them. Although the present invention has been described in detail with reference to the foregoing embodiments, it is to be understood by a person skilled in the art that various changes may still be made to the technical solutions recited in the above embodiments, or equivalents may be substituted for all or some of the features described in the foregoing embodiments; and such changes or substitutions do not make the spirit of corresponding technical solutions depart from the scope of the technical solutions of the embodiments of the present invention.

**Claims**

1. A semiconductor device, comprising:
   a semiconductor body having a first surface and a second surface, the semiconductor body comprising:
   a depletion region,
   a drift region having a first conductivity type,
   an island region having a first conductivity type,
   a buffer region having a first conductivity type,
   the drift region is more proximal to the first surface of the semiconductor body than the buffer region,
   the depletion region is located within the drift region,
   wherein the island region is located within the drift region, an ion concentration of the first conductivity type of the island region is higher than an ion concentration of the first conductivity type of the drift region.

2. The semiconductor device according to claim 1, wherein a Poisson's equation in the drift region is calculated as below:

$$\frac{d^2V}{dx^2} = -\frac{dE}{dx} = -\frac{Q(x)}{\varepsilon_S} = -\frac{qN_D}{\varepsilon_S}$$

   wherein $Q(x)$ is a charge within the depletion region, $\varepsilon_S$ is a dielectric constant for the semiconductor, q is an electron charge, and $N_D$ is an ion impurity concentration in the drift region.

3. The semiconductor device according to claim 2, wherein the body of the semiconductor device further comprises: a semiconductor region of a second conductivity type, an ion concentration of the semiconductor region of the second conductivity type is higher than an ion concentration of the drift region such that the depletion region extends only towards the drift region to maintain a blocking voltage in response to applying a reverse voltage to the semiconductor device.

4. The semiconductor device according to claim 2, wherein a width of the depletion region is $W_D$, and an electric field value becomes zero at $x=W_D$, and an electric field distribution equation is obtained as below:

$$V(x) = \int_0^x E(x)\,dx = \frac{qN_D}{\varepsilon_S}\left(W_D x - \frac{x^2}{2}\right)$$

   wherein the equation is obtained by using a boundary condition that the potential is zero at x=0 within the semiconductor region of the second conductivity type.

5. The semiconductor device according to claim 4, wherein the voltage at the width of the depletion region $W_D$ is equal to an applied reverse bias $V_a$:

$$V_{W_D} = V_a$$

the width of the depletion region $W_D$ is given by:

$$W_D = \sqrt[2]{\frac{2\varepsilon_S V_a}{qN_D}}$$

a position of a top surface of the island region is in a range of 65%$W_D$ to 80% $W_D$, a position of a bottom surface of the island region is at $W_D$, and a thickness of the island region is in a range of 20%$W_D$ to 35% $W_D$.

6. The semiconductor device according to claim 1, wherein the body of the semiconductor device further comprising: a semiconductor region of a second conductivity type, an ion concentration of the semiconductor region of a second conductivity type is close to the ion concentration of the drift region such that the depletion region extends towards the semiconductor region of the second conductivity type and the drift region to maintain a blocking voltage in response to applying a reverse voltage to the semiconductor device.

7. The semiconductor device according to claim 6, wherein a width of the depletion region $W_D$ is calculated as below:

$$W_D = \sqrt[2]{\frac{2\varepsilon_S V_a}{qN_D} \left( \frac{N_A}{N_A + N_D} \right)}$$

wherein $\varepsilon_S$ is a dielectric constant for the semiconductor, q is an electron charge, $N_D$ is an ion impurity concentration in the drift region, $N_A$ is an ion impurity concentration in the semiconductor region of the second conductivity type, and $V_a$ is a reverse bias applied to the semiconductor,

a position of a top surface of the island region is in a range of 65%$W_D$ to 80% $W_D$, a position of bottom surface of the island region is at $W_D$, and a thickness of the island region is in a range of 20%$W_D$ to 35% $W_D$.

8. The semiconductor device according to any one of claims 1 to 7, wherein an ion concentration of the first conductivity type of the buffer region is higher than the ion concentration of the first conductivity type of the drift region.

9. The semiconductor device according to claim 5 or 7, wherein the top surface of the island region is more proximal to the first surface of the semiconductor than the bottom surface of the island region.

10. The semiconductor device according to claim 1, wherein the island region is doped by single peak doping or multi peak doping, and the shape of ion doping profile of the island region comprises any one of the followings: triangle single peak, quadrangle single peak, irregular multi peaks.

11. The semiconductor device according to any one of claims 1 to 7, wherein the semiconductor device comprises any one of the followings: a fast recovery diode, an ultra-fast recovery diode, a standard diode, a MOSFET, and an IGBT switch device.

12. A method for manufacturing a semiconductor device, comprising the steps of:

forming a drift region of a first conductivity type on a semiconductor body,
forming a semiconductor region of a second conductivity type on a first surface of the semiconductor body,
forming a semiconductor region of a first conductivity type on a second surface of the semiconductor body,
forming an island region of the first conductivity type and a buffer region of the first conductivity type on the semiconductor body,
the drift region is more proximal to the first surface of the semiconductor body than the buffer region,
a depletion region is located within the drift region, wherein the island region is located within the drift region, an ion concentration of the first conductivity type of the island region is higher than an ion concentration of the first conductivity type of the drift region.

13. The method according to claim 12, wherein the Poisson's equation in the drift region is calculated as below:

$$\frac{d^2 V}{dx^2} = -\frac{dE}{dx} = -\frac{Q(x)}{\varepsilon_S} = -\frac{qN_D}{\varepsilon_S}$$

wherein Q(x) is a charge within the depletion region, $\varepsilon_S$ is a dielectric constant for the semiconductor, q is an electron charge, and $N_D$ is an ion impurity concentration in the drift region.

**14.** The method according to claim 13, wherein an ion concentration of the semiconductor region of a second conductivity type is higher than the ion concentration of the drift region such that the depletion region extends only towards the drift region to maintain a blocking voltage in response to applying a reverse voltage to the semiconductor device.

**15.** The method according to claim 13, wherein a width of the depletion region is $W_D$, and an electric field value becomes zero at $x=W_D$, and an electric field distribution equation is obtained as below:

$$V(x) = \int_0^x E(x)dx = \frac{qN_D}{\varepsilon_S}\left(W_D x - \frac{x^2}{2}\right)$$

wherein the equation is obtained by using a boundary condition that the potential is zero at x=0 within the semiconductor region of the second conductivity type.

**16.** The method according to claim 13, wherein the voltage at the width of the depletion region $W_D$ is equal to the applied reverse bias $V_a$:

the width of the depletion region $W_D$ is given by:

$$W_D = \sqrt[2]{\frac{2\varepsilon_S V_a}{qN_D}}$$

a position of a top surface of the island region is formed in a range of 65%$W_D$ to 80% $W_D$, a position of a bottom surface of the island region is formed at $W_D$, and a thickness of the island region is formed in a range of 20%$W_D$ to 35% $W_D$.

**17.** The method according to claim 12, wherein an ion concentration of the semiconductor region of a second conductivity type is close to the ion concentration of the drift region such that the depletion region extends towards the semiconductor region of the second conductivity type and the drift region to maintain a blocking voltage in response to applying a reverse voltage to the semiconductor device.

**18.** The method according to claim 17, wherein a width of the depletion region $W_D$ is calculated as below:

$$W_D = \sqrt[2]{\frac{2\varepsilon_S V_a}{qN_D}\left(\frac{N_A}{N_A + N_D}\right)}$$

wherein $\varepsilon_S$ is a dielectric constant for the semiconductor, q is an electron charge, $N_D$ is an ion impurity concentration in the drift region, $N_A$ is theion impurity concentration in the semiconductor region of the second conductivity type, and $V_a$ is a reverse bias applied to the semiconductor,
a position of a top surface of the island region is in a range of 65% $W_D$ to 80% $W_D$, a position of bottom surface of the island region is at $W_D$, and a thickness of the island region is in a range of 20% $W_D$ to 35% $W_D$.

**19.** The method according to any one of claims 12 to 18, wherein an ion concentration of the first conductivity type of the buffer region is higher than the ion concentration of the first conductivity type of the drift region.

**20.** The method according to claim 12, wherein the island region is formed by a proton implantation process or an EPI growth process.

**21.** The method according to claim 16 or 18, wherein the top surface of the island region is more proximal to the first surface of the semiconductor than the bottom surface of the island region.

**22.** The method according to claim 12, wherein the island region is doped by single peak doping or multi peak doping, and the shape of ion doping profile of the island region comprises any one of the followings: triangle single peak, quadrangle single peak, irregular multi peaks.

**23.** The method according to any one of claims 12 to 18, wherein the position of the top surface of the island region is formed in a range of 65% $W_D$ to 80% $W_D$, the position of the bottom surface of the island region is formed at $W_D$, the method comprising: determining an implantation depth of the island region according to the width $W_D$ of the depletion region, and determining a proton implantation energy according to the corresponding relationship between the proton implantation energy and the implantation depth of the island region, such that the position of the top surface of the island region is formed in a range 65% $W_D$ to 80% $W_D$, and the position of the bottom surface of the island region is formed at $W_D$.

FIG. 1A

FIG. 1B

FIG. 2

FIG. 3

FIG. 4

FIG. 5

FIG. 6

**FIG. 7**

**FIG. 8**

30

20

40

Phos implant

# FIG. 9

30

20

40 41 H+ (proton) implant

# FIG. 10

30

20

40 41 42 H+ (proton) implant

# FIG. 11

**FIG. 12**

**FIG. 13**

Europäisches
Patentamt

European
Patent Office

Office européen
des brevets

# EUROPEAN SEARCH REPORT

Application Number

EP 23 17 1478

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/217627 A1 (FRIEDRICHS PETER [DE] ET AL) 11 September 2008 (2008-09-11) | 1-22 | INV.<br>H01L29/36 |
| A | * paragraphs [0032], [0056] - [0062]; figures 2,2A * | 23 | H01L21/329<br>H01L29/739<br>H01L29/78 |
| X | EP 2 913 854 A1 (FUJI ELECTRIC CO LTD [JP]) 2 September 2015 (2015-09-02)<br>* paragraphs [0048] - [0061], [0103] - [0107]; figures 1,9-15 * | 1-23 | H01L29/861 |

TECHNICAL FIELDS
SEARCHED      (IPC)

H01L

The present search report has been drawn up for all claims

| Place of search | Date of completion of the search | Examiner |
|---|---|---|
| Munich | 22 September 2023 | Melodia, Andrea |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 23 17 1478

This annex lists the patent family members relating to the patent documents cited in the above-mentioned European search report.
The members are as contained in the European Patent Office EDP file on
The European Patent Office is in no way liable for these particulars which are merely given for the purpose of information.

22-09-2023

| Patent document cited in search report | | Publication date | Patent family member(s) | | Publication date |
|---|---|---|---|---|---|
| US 2008217627 | A1 | 11-09-2008 | DE 102005046707 | B3 | 03-05-2007 |
| | | | EP 1946377 | A2 | 23-07-2008 |
| | | | KR 20080070638 | A | 30-07-2008 |
| | | | US 2008217627 | A1 | 11-09-2008 |
| | | | WO 2007036456 | A2 | 05-04-2007 |
| EP 2913854 | A1 | 02-09-2015 | CN 104620391 | A | 13-05-2015 |
| | | | EP 2913854 | A1 | 02-09-2015 |
| | | | JP 6090329 | B2 | 08-03-2017 |
| | | | JP WO2014065080 | A1 | 08-09-2016 |
| | | | TW 201432916 | A | 16-08-2014 |
| | | | US 2015179441 | A1 | 25-06-2015 |
| | | | US 2019115211 | A1 | 18-04-2019 |
| | | | US 2021098252 | A1 | 01-04-2021 |
| | | | WO 2014065080 | A1 | 01-05-2014 |

EPO FORM P0459

For more details about this annex : see Official Journal of the European Patent Office, No. 12/82